# EUROPEAN PATENT SPECIFICATION

(11) **EP 2 514 991 B1**
(45) Date of publication and mention of the grant of the patent: **08.07.2015**
(21) Application number: 12164126.0
(22) Date of filing: 13.04.2012
(51) Int. Cl.: F16F 1/12, H05K 1/14

(54) **Holding element**
Halteelement
Élément de support

(30) Priority: 20.04.2011 TR 201103841
(43) Date of publication of application: 24.10.2012
(73) Proprietor: Vestel Beyaz Esya Sanayi ve Ticaret A.S., 45030 Manisa (TR)
(72) Inventor: Baburoglu, Mehmet Soner, 45030 Manisa (TR); Ozcelikyildiz, Benal, 45030 Manisa (TR)
(74) Representative: Cayli, Hülya

(56) References cited:
- JP-A- 2000 097 969
- US-A1- 2009 045 562

## Description

### Technical Field

The present invention relates to holding elements which are used for fixing a control card to a panel.

### Prior Art

Circuit boards comprising electronic circuits in electronic home appliances are fixed to at least one panel of the home appliance. Especially in stove type heating devices comprising touch control unit, such circuit boards are fixed to a panel with a flexible holding elements. Therefore, when the height of the upper panel of the device comprising touch part is changed, it is ensured that the position of the circuit board comprising touch buttons is not changed with respect to the upper panel.

The patent document no US2009045562A1 considered to be the closest prior art in the state of art discloses a distancing element used for fixing a circuit board to a panel. Said distancing element comprises a spacer comprising a connection element for being connected to a circuit board in one side; a spring placed in a slot in the spacer; and a fastener engaged to the slot and connected to the panel from one side. However; in said system, the spacer and the holding element can be separated when a force is exerted on the panel from a different angle, and the circuit board can be disconnected from the panel.

The other patent document no JP2000097969A in the state of art discloses a suspension system. Said system comprises a main body; a connection element provided in one side of the main body and for connecting to a panel; a spring engaged to the body; a plate holding the spring, and another plate engaged to the upper part of the spring. Said system can be connected to another panel from other side of the main body. In said suspension system, said spring is exposed and thus can easily be affected by the environmental factors. Furthermore the connections used in said document are made of metal material and when a leak is occurred in the device, it can cause the leak to arrive to the panel.

### Brief Description of the Invention

An electronic home appliance of the invention comprises at least one touch panel; at least one circuit board which is positioned in the side of the touch panel facing inner part of the device and which is provided with at least one electronic circuit and at least one touch button thereon; at least one connection panel to which said circuit board is connected; and at least one holding element which is for connecting the circuit board to the panel, and which comprises at least one holding body which is engaged to the circuit board from at least one side and to the panel from at least one other side and which is in a uniform structure, at least one elastic element which is engaged to the holding body and at least one movable plate which is engaged to the holding body, which is in contact with said elastic element from at least one side, and which is in contact with the panel or the circuit board from at least one other side.

The movable plate provided in the holding element and the holding body are able to move with respect to each other. Said movement is able to be controlled via said elastic element. Thanks to said controlled movement, movement of the circuit board towards the touch panel is ensured.

### Objectives of the Invention

The aim of the invention is to develop an electronic home appliance comprising a holding element which fixes a control unit to a panel of the device in the electronic home appliances comprising touch control panel.

The other aim of the present invention is to develop a home appliance comprising a holding element which ensures that the circuit board remains in contact with the touch upper panel of the device.

Another aim of the present invention is to develop a home appliance comprising a cost effective and reliable holding element which is easy to produce and assemble.

### Description of the Drawings

Exemplary embodiments of an electronic home appliance comprising a holding element of the invention are shown in the attached figures wherein;
Figure 1 is a lateral cross section of a part of the home appliance comprising the holding element.
Figure 2 is a lateral cross section of a circuit board to which the holding element is engaged.
Figure 3 is a lateral cross section of a panel to which the holding element is engaged.
Figure 4 is a perspective view of the holding element.
Figure 5 is a side view of a holding body provided in the holding element.
Figure 6 is a perspective view of a movable plate piece comprised by the holding element.
Figure 7 is a side view of an elastic element comprised by the holding element.
Figure 8 is a perspective view of an alternative embodiment of the movable plate piece comprised by the holding element.
Figure 9 is a lateral cross section view of the part comprising the holding element of the home appliance which comprises a touch upper panel.

The parts in the figures are individually enumerated and the corresponding terms of reference numbers are given as follows:
- Circuit board: (C)
- Connection panel: (P)
- Touch panel: (T)
- Holding element: (H)
- Touch button: (S)
- Holding body: (1)
- Movable plate: (2)
- Elastic element: (3)
- Connection element: (4, 5)
- Holding protrusion: (6, 7)
- Hole: (9, 11, 12)

### Description of the Invention

In electronic home appliances comprising at least one touch panel, at least one circuit board comprising at least one electronic circuit and at least one touch button is positioned in a part of the touch panel facing inside the device. In order to operate the touch buttons on the board properly, the position of the circuit board with respect to the touch panel is not to be necessarily changed. For this reason, the present invention discloses a home appliance comprising a holding element which ensures that the position of the circuit board with respect to the touch panel is not changed.

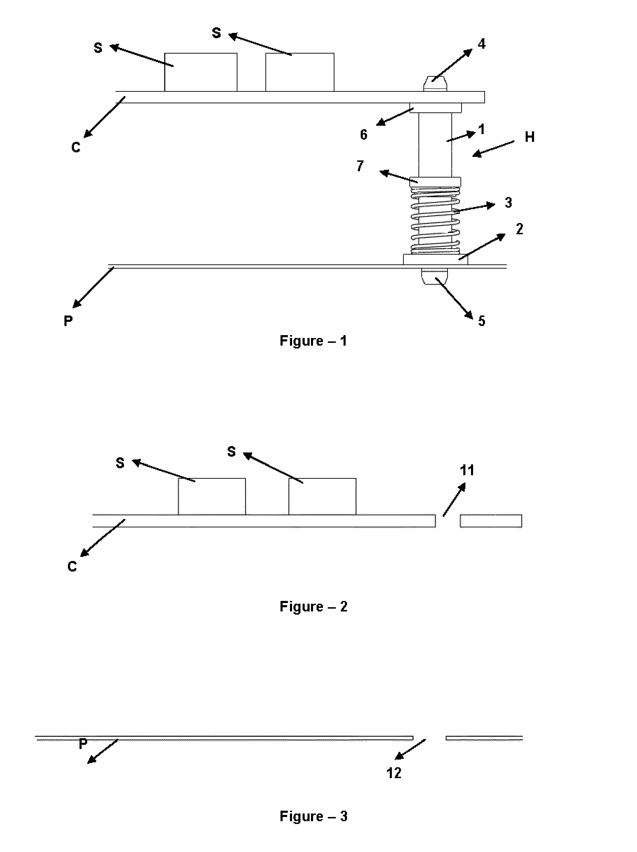

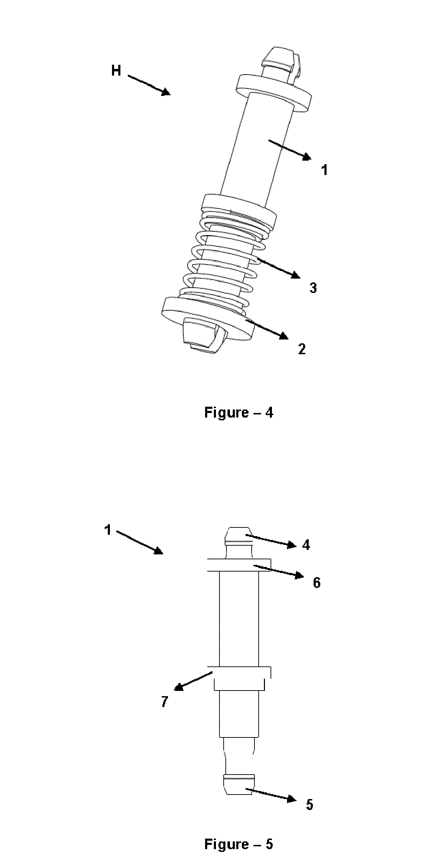

Said home appliance, as shown in figure 1, comprises at least one circuit board (C) which comprises at least one touch button (S) and at least one electronic circuit thereon, and a cross section of which is shown in figure 2; at least one connection panel (P) to which the circuit board (C) is connected and a cross section of which is shown in figure 3; and at least one holding element (H) for ensuring the connection of the circuit board (C) to the panel (P). The holding element (H), detailed view of which is shown in figure 4, comprises at least one holding body (1) which is engaged to the circuit board (C) from at least one side and to the panel (P) from at least one other side and which is in a uniform structure; at least one elastic element (3) which is engaged to the holding body (1) and which is preferably a spring; and at least one movable plate (2) which is engaged to the holding body (1) from at least one side, which is in contact with said elastic element (3) from at least one side, and which is in contact with the panel (P) or the circuit board (C) from at least one other side.

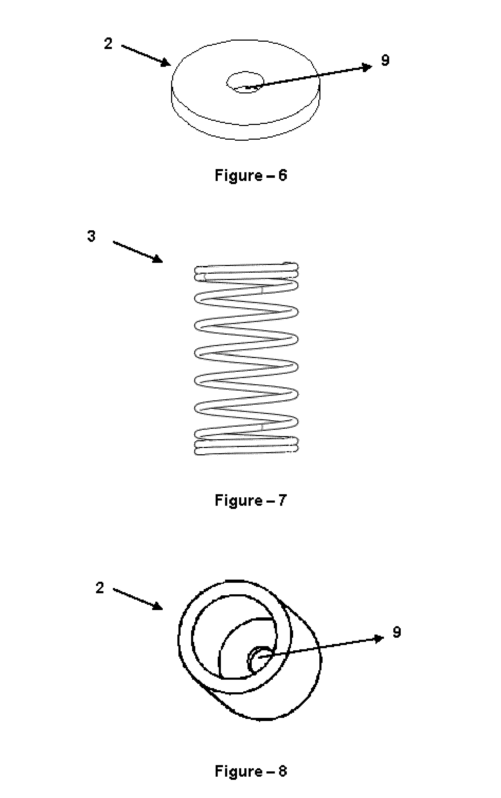

The holding body (1), detailed view of which is shown in figure 5, is in a uniform structure comprising at least two connection elements (4, 5) which are located at least two sides of the body (1), which ensure the connection of the holding body (1) to the circuit board (C) and to the panel (P) and which are preferably in a snapped structure; at least two holding plates (6, 7) which are placed between these two connection elements (4, 5) and which are in the form of protrusion on the body (1). The movable plate (2), an exemplary view of which is shown in figure 6 and which comprises at least one hole (9), is in a state that engaged to the holding body (1) by passing through at least one connection element (5). The elastic element (3) shown as a spring in figure 7 is located between said movable plate (2) and a holding plate (7). The movable plate (2) is able to move with respect to the holding body (1) with the stretch or compression of the elastic element (3). Said movable plate (2) is preferably in the form of bushing encircling the elastic element (3) as shown in figure 8.

The holding element (H) is fixed to the circuit board (C) by passing at least one connection element (4) provided on the holding body (1) through at least one hole (11) provided on the circuit board (C) and by remaining of the circuit board (C) between the connection element (4) and one of the holding plates (6). The holding element (H) is engaged to the panel (P) by passing at least one another connection element (5) through at least one another hole (12) provided on the panel (P) and by remaining of the panel (P) between the connection element (5) and the movable plate (2). The movable plate (2) in contact with the panel (P) and the holding body (1) are able to move with respect to each other.

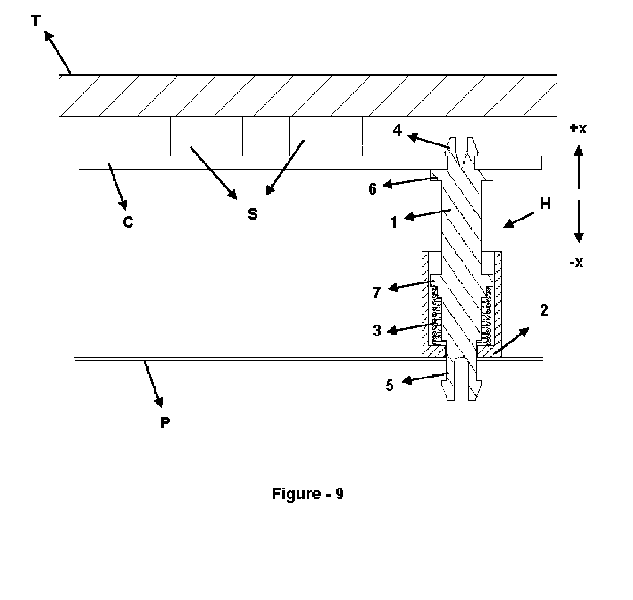

Figure 9 shows a lateral cross section of the part comprising the holding element (H) of the home appliance which comprises a touch panel (T) and which can be preferably a cooking device. During the assembly of the touch panel (T) to the device, the touch panel (T) moves the circuit board (C) towards the connection panel (P) (at -x direction). In said situation, the circuit board (C) exerts a force on the holding plate (6), which is provided in the holding element (H) and which is in contact with the circuit board (C), at moving direction (-x), and ensures moving of the holding element (H) in said direction (-x). Since the movable plate (2) provided in the holding element (H) is in contact with the connection panel (P), when the holding element (H) moves towards the panel (P) (at -x direction), the holding body (1) moves with respect to the movable plate (2) and force accumulates on the elastic element (3) provided between the movable plate (2) and the holding plate (7). Therefore the circuit board (C), which is fixed to the holding element (H), moves towards the connection panel (P). When the position of the touch panel (T) changes (i.e. when the touch panel (T) moves away from the connection panel (P)), the elastic element (3) provided in the holding element (H) exerts force on the circuit board (C) towards the touch panel (T) (+x). With said force, it is ensured that the circuit board (C) moves together with the touch panel (T). Therefore, the change of the position of the touch buttons (S) provided on the circuit board (C) with respect to the touch panel (P) is prevented and proper operating of said buttons (S) is ensured.

In a preferred embodiment of the invention, the holding element (H) is made of an insulating material such as plastic. Thus; even if there is an electrical leak, its arrival to the connection panel (P) is prevented and more secure home appliance is provided.

## Claims

1. An electronic home appliance comprising at least one touch panel (T); at least one circuit board (C) which is positioned in a side of the touch panel (T) facing inner part of the device and which is provided with at least one electronic circuit and at least one touch button (S) thereon; at least one connection panel (P) to which said circuit board (C) is connected; and at least one holding element (H) for connecting the circuit board (C) to the panel (P) **characterized in that** said holding element (H) comprises
- at least one holding body (1) which is engaged to the circuit board (C) from at least one side and to the panel (P) from at least one other side and which is in a uniform structure;
- at least one elastic element (3) which is engaged to the holding body (1); and
- at least one movable plate (2) which is engaged to the holding body (1), which is in contact with said elastic element (3) from at least one side, and which is in contact with the panel (P) or the circuit board (C) from at least one other side.

2. A home appliance according to claim 1 **characterized in that** the holding body (1) comprises at least one connection element (4) provided in at least one side of the holding body (1) for ensuring the connection of the holding body (1) to the circuit board (C).

3. A home appliance according to claim 1 or 2 **characterized in that** the holding body (1) comprises at least one another connection element (5) provided in at least one side of the holding body (1) for ensuring the connection of the holding body (1) to the panel (P).

4. A home appliance according to claim 3 **characterized in that** said holding body (1) comprises at least one holding plate (6) which is placed between two connection elements (4, 5) and in the form of protrusion on the body (1).

5. A home appliance according to claim 3 **characterized in that** said holding body (1) comprises at least one another holding plate (7) which is placed between two connection elements (4, 5) and in the form of protrusion on the body (1).

6. A home appliance according to claim 3 **characterized in that** said connection elements (4, 5) are in a snapped structure.

7. A home appliance according to claim 1 **characterized in that** the movable plate (2) comprises at least one hole (9) for engaging the plate (2) to the holding body (1).

8. A home appliance according to claim 3 **characterized in that** said elastic element (3) is positioned between the movable plate (2) and at least one holding plate (7).

9. A home appliance according to claim 3 **characterized in that** the circuit board (C) comprises at least one hole (11) for the engagement of at least one connection element (4).

10. A home appliance according to claim 3 **characterized in that** the panel (P) comprises at least one hole (12) for the engagement of at least one connection element (5).

11. A home appliance according to claim 1 **characterized in that** said movable plate (2) is a bushing.

12. A home appliance according to claim 1 **characterized in that** said elastic element (3) is at least one spring.

13. A home appliance according to claim 1 **characterized in that** said holding element (H) is made of plastic material.

## Patentansprüche

1. **Elektronisches Haushaltsgerät** mit zumindest einer Berührungsanzeige (T; touch panel); zumindest einer Platine (C), die an oder in einer Seite der Berührungsanzeige (T) angeordnet ist, die dem inneren Teil der Vorrichtung zugewandt ist, und zumindest eine elektronische Schaltung und zumindest eine Berühr- oder Drucktaste (S) aufweist; zumindest einer Anschlussplatte (P), mit der die Platine (C) verbunden ist; und mit zumindest einem Halteelement (H) zum Verbinden der Platine (C) mit der Platte (P), **dadurch gekennzeichnet, dass** das Halteelement (H) umfasst
- zumindest einen Haltekörper (1), der von zumindest einer Seite an der Platine (C) angreift und von zumindest einer anderen Seite an der Platte (P) angreift und der eine gleichmäßige Struktur aufweist;
- zumindest ein elastisches Element (3), das am Haltekörper (1) angreift; und
- zumindest einen bewegbaren Teller oder Platte (2), der am Haltekörper (1) angreift, der von zumindest einer Seite mit dem elastischen Element (3) in Kontakt steht, und der von zumindest einer anderen Seite mit der Platte (P) oder der Platine (C) in Kontakt steht.

2. Haushaltsgerät nach Anspruch 1, **dadurch gekennzeichnet, dass** der Haltekörper (1) zumindest ein Verbindungselement (4) umfasst, das an oder in zumindest einer Seite des Haltekörpers (1) vorgesehen ist, zum Sicherstellen der Verbindung des Haltekörpers (1) mit der Platine (C).

3. Haushaltsgerät nach Anspruch 1 oder 2, **dadurch gekennzeichnet, dass** der Haltekörper (1) zumindest ein weiteres Verbindungselement (5) umfasst, das an oder in zumindest einer Seite des Haltekörpers (1) vorgesehen ist, zum Sicherstellen der Verbindung des Haltekörpers (1) mit der Platte (P).

4. Haushaltsgerät nach Anspruch 3, **dadurch gekennzeichnet, dass** der Haltekörper (1) zumindest eine Halteplatte (6) umfasst, die zwischen zwei Verbindungselementen (4, 5) platziert ist und die als Vorsprung des Haltekörpers (1) ausgebildet ist.

5. Haushaltsgerät nach Anspruch 3, **dadurch gekennzeichnet, dass** der Haltekörper (1) zumindest eine weitere Halteplatte (7) umfasst, die zwischen zwei Verbindungselementen (4, 5) platziert ist und die als Vorsprung des Haltekörpers (1) ausgebildet ist.

6. Haushaltsgerät nach Anspruch 3, **dadurch gekennzeichnet, dass** die Verbindungselemente (4, 5) eine einrastbare Struktur aufweisen.

7. Haushaltsgerät nach Anspruch 1, **dadurch gekennzeichnet, dass** der bewegbare Teller oder Platte (2) zumindest ein Loch (9) umfasst, zum Verbinden des Tellers oder der Platte (2) mit dem Haltekörper (1).

8. Haushaltsgerät nach Anspruch 3, **dadurch gekennzeichnet, dass** das elastische Element (3) zwischen dem bewegbaren Teller oder Platte (2) und zumindest einer Halteplatte (7) positioniert ist.

9. Haushaltsgerät nach Anspruch 3, **dadurch gekennzeichnet, dass** die Platine (C) zumindest ein Loch (11) umfasst, für das An- oder Eingreifen von zumindest einem Verbindungselement (4).

10. Haushaltsgerät nach Anspruch 3, **dadurch gekennzeichnet, dass** die Platte (P) zumindest ein Loch (12) umfasst, für An- oder Eingreifen von zumindest einem Verbindungselement (5).

11. Haushaltsgerät nach Anspruch 1, **dadurch gekennzeichnet, dass** der bewegbare Teller oder Platte (2) eine Hülse oder ein Lager ist.

12. Haushaltsgerät nach Anspruch 1, **dadurch gekennzeichnet, dass** das elastische Element (3) zumindest eine Feder ist.

13. Haushaltsgerät nach Anspruch 1, **dadurch gekennzeichnet, dass** das Halteelement (H) aus Kunststoff hergestellt wurde.

## Revendications

1. Appareil ménager électronique comprenant au moins un panneau tactile (T) ; au moins une carte de circuit (C) qui est positionnée dans un côté du panneau tactile (T) faisant face à une partie intérieure du dispositif et qui est pourvue d'au moins un circuit électronique et d'au moins un bouton tactile (S) dessus ; au moins un panneau de connexion (P) auquel ladite carte de circuit (C) est connectée ; et au moins un élément de support (H) pour connecter la carte de circuit (C) au panneau (P), **caractérisé en ce que** ledit élément de support (H) comprend
- au moins un corps de support (1) qui est en prise avec la carte de circuit (C) à partir d'au moins un côté et avec le panneau (P) à partir d'au moins un autre côté et qui est dans une structure uniforme ;
- au moins un élément élastique (3) qui est en prise avec le corps de support (1) ; et
- au moins une plaque mobile (2) qui est en prise avec le corps de support (1), qui est en contact avec ledit élément élastique (3) à partir d'au moins un côté, et qui est en contact avec le panneau (P) ou la carte de circuit (C) à partir d'au moins un autre côté.

2. Appareil ménager selon la revendication 1, **caractérisé en ce que** le corps de support (1) comprend au moins un élément de connexion (4) pourvu dans au moins un côté du corps de support (1) pour assurer la connexion du corps de support (1) à la carte de circuit (C).

3. Appareil ménager selon la revendication 1 ou 2, **caractérisé en ce que** le corps de support (1) comprend au moins un autre élément de connexion (5) pourvu dans au moins un côté du corps de support (1) pour assurer la connexion du corps de support (1) au panneau (P).

4. Appareil ménager selon la revendication 3, **caractérisé en ce que** ledit corps de support (1) comprend au moins une plaque de support (6) qui est placée entre deux éléments de connexion (4, 5) et sous forme de saillie sur le corps (1).

5. Appareil ménager selon la revendication 3, **caractérisé en ce que** ledit corps de support (1) comprend au moins une autre plaque de support (7) qui est placée entre deux éléments de connexion (4, 5) et sous forme de saillie sur le corps (1).

6. Appareil ménager selon la revendication 3, **caractérisé en ce que** lesdits éléments de connexion (4, 5) sont dans une structure encliquetée.

7. Appareil ménager selon la revendication 1, **caractérisé en ce que** la plaque mobile (2) comprend au moins un trou (9) pour mettre en prise la plaque (2) avec le corps de support (1).

8. Appareil ménager selon la revendication 3, **caractérisé en ce que** ledit élément élastique (3) est positionné entre la plaque mobile (2) et au moins une plaque de support (7).

9. Appareil ménager selon la revendication 3, **caractérisé en ce que** la carte de circuit (C) comprend au moins un trou (11) pour la mise en prise d'au moins un élément de connexion (4).

10. Appareil ménager selon la revendication 3, **caractérisé en ce que** le panneau (P) comprend au moins un trou (12) pour la mise en prise d'au moins un élément de connexion (5).

11. Appareil ménager selon la revendication 1, **caractérisé en ce que** ladite plaque mobile (2) est une douille.

12. Appareil ménager selon la revendication 1, **caractérisé en ce que** ledit élément élastique (3) est au moins un ressort.

13. Appareil ménager selon la revendication 1, **caractérisé en ce que** ledit élément de support (H) est réalisé en matière plastique.
